# EUROPEAN PATENT APPLICATION

(11) **EP 3 081 946 A1**
(43) Date of publication of application: **19.10.2016**
(21) Application number: 16163378.9
(22) Date of filing: 31.03.2016
(51) Int. Cl.: G01R 13/02, G01R 13/34

(54) **INTENSITY INFORMATION DISPLAY**

(30) Priority: 31.03.2015 US 201514675346
(71) Applicant: Tektronix, Inc., Beaverton, Oregon 97077-0001 (US)
(72) Inventor: LETTS, Peter, Beaverton, Oregon 97006 (US)
(74) Representative: Clarke, Jeffrey David

(57) **Abstract**

A method can include generating raster images from digitized signals, each raster image including multiple pixels that each have a count of the number of signals that pass through it, and generating sets of ranges of counts from the totality of counts in a rasterizer image and selected limits on that totality. The method can also include generating mapped images from the raster images and sets of ranges of counts, each mapped image including multiple pixels that each have an output intensity determined by the specific range of counts that contains the corresponding rasterizer image pixel count.

## Description

### Technical Field

The present disclosure relates generally to test and measurement apparatuses, such as oscilloscopes. In particular, oscilloscopes capable of providing output intensity information are described.

### Background

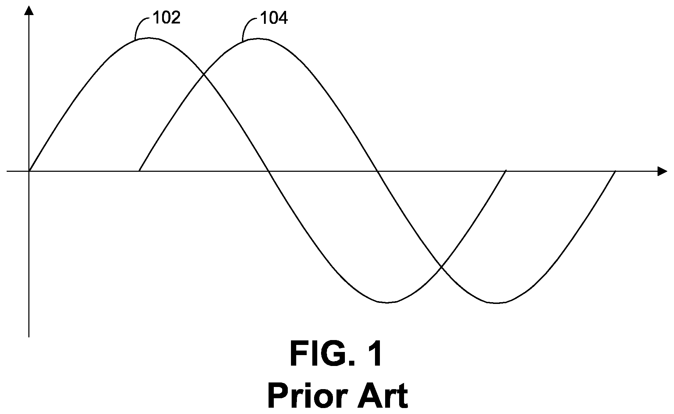

FIGURE 1 illustrates prior art waveforms 102 and 104 displayed by an oscilloscope where both waveforms have the same pixel intensity.

In prior oscilloscopes, mapping functions are typically based on a set of thresholds that are derived (e.g., globally) from the distribution of hit counts, with all counts between an adjacent pair of thresholds being mapped to the same single output intensity. Also, to simulate earlier instrument phosphor displays, the hit counts are reduced (e.g., decayed) on each display update so that only frequently occurring waveform values are retained.

There remains a need for oscilloscopes that improve upon and advance the functionalities of known oscilloscopes. Examples of new and useful oscilloscopes relevant to the needs existing in the field are discussed below.

### Summary

Implementations of the disclosed technology are generally directed to oscilloscopes having a digitizer configured to digitize input data into a plurality of digitized signals and a rasterizer configured to generate a plurality of raster images from the plurality of digitized signals, each raster image including a plurality of pixels, each pixel having a count of the number of digital signals that have passed through it. Such oscilloscopes may also include a processor configured to generate a plurality of mapped images from the plurality of rasterizer images and a plurality of sets of ranges of counts, each mapped image including a plurality of pixels, each pixel having an output intensity determined by the range of counts that contains the corresponding rasterizer image pixel count. Such oscilloscopes may also include a display device configured to display the mapped images and provide an indication as to at least one of the counts in the corresponding rasterizer image.

### Brief Description of the Drawings

FIGURE 1 is an example of a screenshot illustrating prior art waveforms displayed by an oscilloscope where both waveforms have the same pixel intensity.
FIGURE 2 is a block diagram illustrating an oscilloscope that is suitable for displaying waveforms in accordance with certain implementations of the disclosed technology.
FIGURE 3 is a first example of a screenshot illustrating modulated waveforms with a wide range of output intensities displayed by an oscilloscope with existing technology.
FIGURE 4 is a second example of a screenshot illustrating a selected subset of the same modulated waveforms displayed by an oscilloscope in accordance with certain implementations of the disclosed technology.
FIGURE 5 is a flowchart illustrating a method in accordance with certain implementations of the disclosed technology.

### Detailed Description

In prior oscilloscopes, such as those described above, significantly more information is collected in the raster plane than is made available to the user. Historically, with relatively noisy analog waveforms, the detailed information was not very valuable. With current digital and frequency waveforms, however, it is possible that the detailed hit counts could provide useful diagnostic or quantitative information, particularly if the decay function is disabled so that all waveforms are counted and the information in the raster plane is complete.

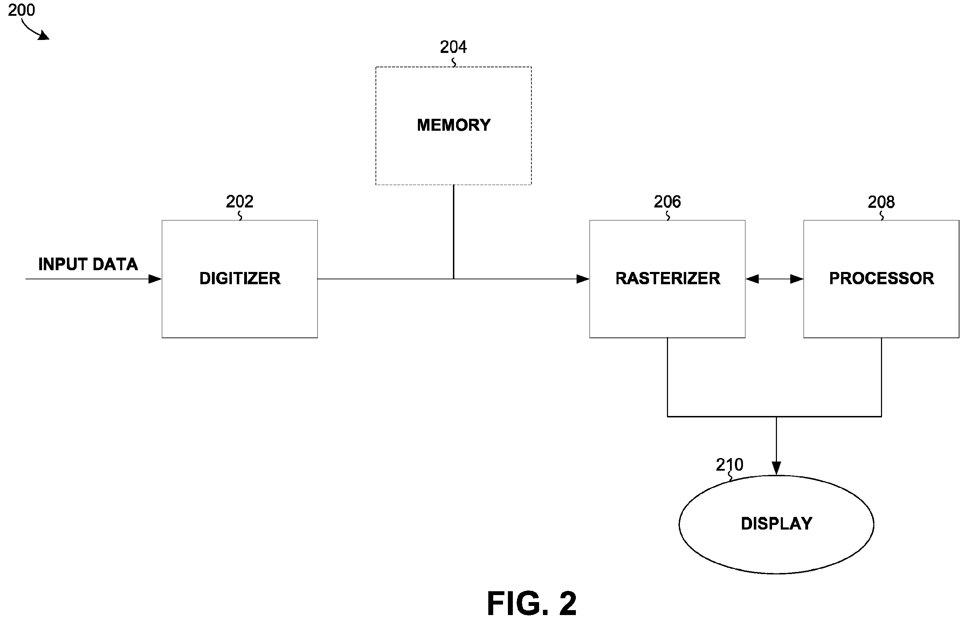

FIGURE 2 is a block diagram illustrating an oscilloscope 200 that is suitable for displaying waveforms in accordance with certain implementations of the disclosed technology. Oscilloscope 200 includes a digitizer 202, an optional memory 204, a rasterizer 206, a processor 208, and a display 210.

The digitizer 202 acquires input data and transforms that data into a digital representation. For example, the digitizer 202 may include a successive approximation analog-to-digital converter (ADC) operating in a real-time sampling mode, sampling as often as possible. Alternatively, the digitizer 202 may include a direct conversion ADC operating in an equivalent-time sampling mode, sampling at a determined time period after a triggering event.

During general operation, the digitized signal is rasterized in rasterizer 206 into a raster image (not shown) to be displayed as a two dimensional (m x n) array of pixels on display 210. The rasterizer 206 has the ability to rasterize acquired waveforms and add them to a two-dimensional (m x n) array of hit counts, e.g., the rasterizer plane. The counts can be 32 bits or more but the information contained in them is typically compressed (e.g., mapped) to 5 or 6 intensity bits for display purposes.

The memory 204 is shown as being located between the digitizer 202 and the rasterizer 206; however, such memory storage is not required. For example, the digitizer 202 may send digitized signals directly to the rasterizer 206 rather than through the memory 204.

The processor 208 may communicate directly or indirectly with the rasterizer 206. For example, a data bus (not shown) may link the processor 208 and the rasterizer 206. In addition, the processor 210 may communicate with the rasterizer 206 through a common memory (not shown). However, the common memory may be the memory 204 itself or another memory separate from the memory 204.

Mapping functions in prior instruments are typically linear between the minimum and maximum hit counts, or histogram equalization that optimizes the use of available intensity levels. They usually include an ability to skew the entire output to either high or low intensity values. Other modifications to the output intensities may include inversion, which highlights infrequent glitches, and thermal palettes that use color rather than brightness, for example, to provide an indication of frequency of occurrence.

Other uses of the data in the raster plane may include vertical and horizontal histograms that show the relative total hit counts in specified subsets of individual rows or columns. There may also be cursor readouts that show individual waveform or potential histogram values.

In certain embodiments, a digitized signal is rasterized in an oscilloscope rasterizer (such as the rasterizer 206 of FIGURE 2) into a raster image to be displayed as a two dimensional (m x n) array of pixels on a display of the oscilloscope. A raster image may be formed of multiple pixels that are arranged in an m x n array of rows and columns. For example, a rasterizer plane may be 512 x 1024 bytes, where each pixel is made up of a total of 32 bits, of which 5 or 6 are dedicated for pixel type information and the rest are counters.

In certain embodiments, there may be tens of thousands of new acquisitions per second that are added individually by the rasterizer to one of a pair of rasterizer planes. Display updates may occur 25 times per second and may be performed by a mapper and inter-demultiplexer communication bus (IDC).

In such embodiments, when the mapper is about to run, the current (e.g., old) rasterizer plane is copied to the other (e.g., new) rasterizer plane. The mapper may then process the current rasterizer plane while the rasterizer continues to accumulate to the other plane.

Hit counts may be passed through a cascade of a certain number of thresholds (e.g., 16) in order to determine an output intensity (e.g., 5 bits). In certain embodiments, the least significant bit (e.g., of 5 bits) may be determined by interpolation between a threshold above its value and a threshold below its value.

Pixels having a hit count below the lowest threshold may be automatically mapped to a lowest output intensity (e.g., zero). Pixels having a hit count above the lowest threshold may be mapped to a particular output intensity corresponding to one of a set of ranges between the lowest threshold and the highest threshold. Pixels having a hit count above the highest threshold may be mapped to an effective lowest output intensity (e.g., after having been shifted up by a bit from the highest output intensity in the transfer to the display plane by the IDC).

In certain implementations of the disclosed technology, a user may be enabled to select a specific (e.g., contiguous) subset between the minimum and maximum of a particular range of hit counts. Such implementations may specify that only the subset is mapped to the full set of output intensities.

In other implementations of the disclosed technology, a user may be enabled to select an individual hit count in the display with a cursor (e.g., a two-dimensional cursor) and provide a readout of its value. For example, a user may move the cursor to an area of infrequent counts to determine an exact count.

In certain implementations, an oscilloscope may acquire a specified number of waveforms and then stop. In such embodiments, a specific number of waveforms may be acquired with infinite persistence (e.g., no decay). Varying sized ranges of hit counts just above the minimum may be used to highlight infrequent glitches.

In areas of significant variability (e.g., fat waveforms), the limited subset mapping capability may be used to identify points with the highest and lowest hit counts. In both cases, the cursor capability may be used to determine the actual hit counts, and may also provide percentages of the total number of waveforms.

Certain implementations of the disclosed technology may include analyzing data such as peak detect or envelope waveforms, which typically appear as almost completely saturated displays.

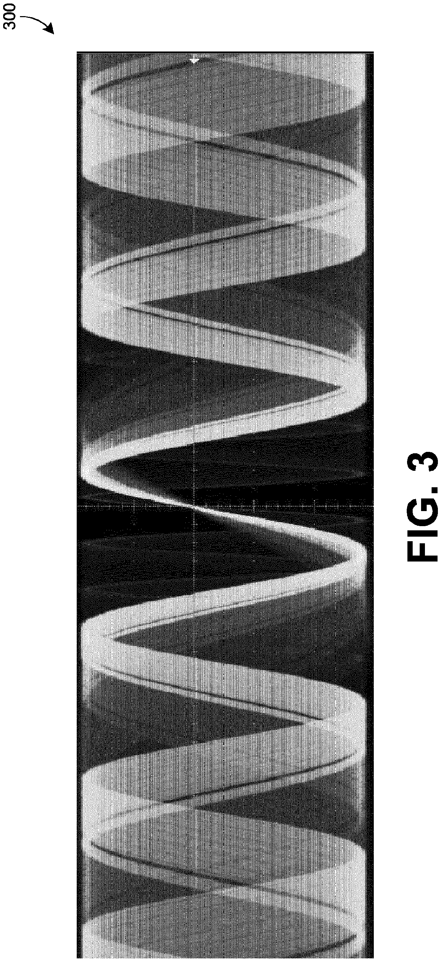

FIGURE 3 is a first example 300 of a screenshot illustrating modulated waveforms with a wide range of output intensities displayed by an oscilloscope with existing technology. In the example, it is not immediately apparent which waveform values occur most frequently.

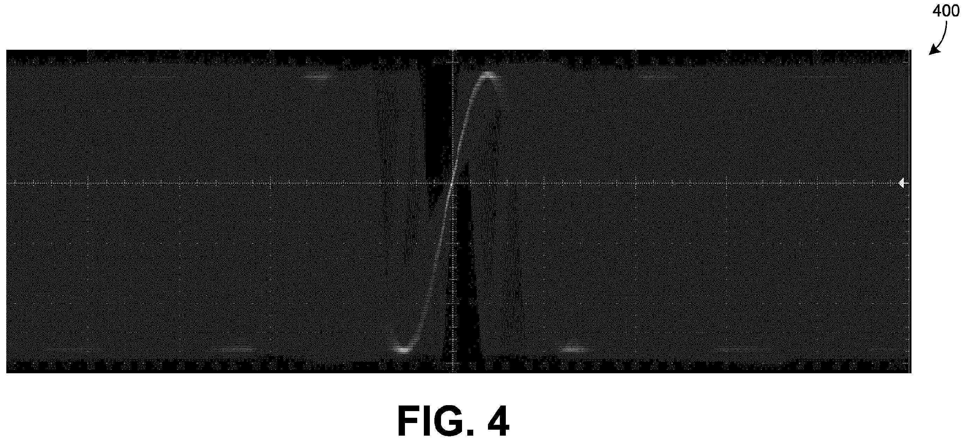

FIGURE 4 is a second example 400 of a screenshot illustrating modulated waveforms displayed by an oscilloscope in accordance with certain implementations of the disclosed technology. In the example, a selected subset of waveform values and frequencies is highlighted.

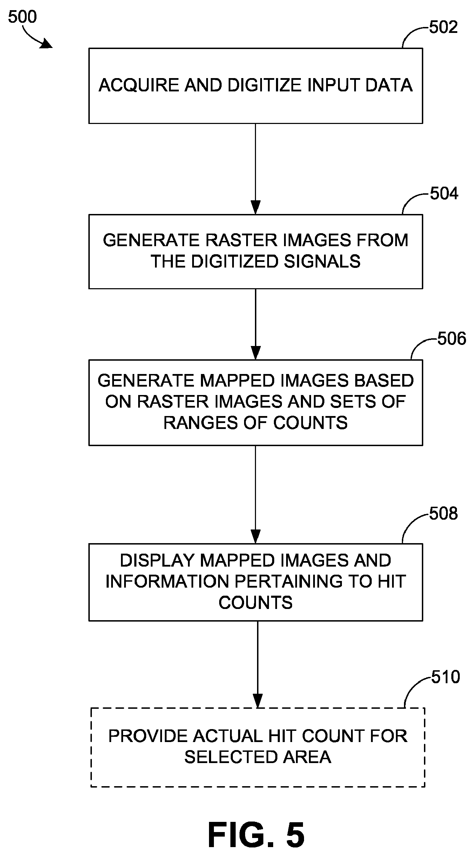

FIGURE 5 is a flowchart illustrating a method 500 in accordance with certain implementations of the disclosed technology. At 502, an oscilloscope acquires input data and a digitizer of the oscilloscope digitizes the input data into digitized signals.

At 504, a rasterizer of the oscilloscope generates raster images from the digitized signals, each raster image having multiple pixels that each have a count of the signals that pass through it.

At 506, a processor of the oscilloscope determines whether the count at each rasterizer pixel is within one of a number of count ranges and, for each pixel having a count within one of the count ranges, generates a mapper pixel with the corresponding output intensity. That is, a mapper may be configured to generate mapped images from the rasterizer images and sets of ranges of counts, each mapped image including multiple pixels, each pixel having an output intensity determined by the specific range of counts that contains the corresponding rasterizer image pixel count.

At 508, a display device of the oscilloscope displays the mapper images and provides an indication as to at least one of the counts corresponding to the output intensity ranges.

At 510, a user may optionally cause a cursor to move over a particular point within the displayed images and, responsive thereto, the display of the oscilloscope may further provide a visual indication of the rasterizer hit count corresponding to the particular point, for example.

Examples provide an oscilloscope, comprising a digitizer configured to digitize acquired input data into a plurality of digitized signals, a rasterizer configured to generate a plurality of raster images from the plurality of digitized signals, each raster image including a plurality of pixels, each pixel having a count of the number of signals that pass through it, an input device configured to generate sets of ranges of counts from the totality of counts in a rasterizer image and selected limits on that totality, a mapper configured to generate a plurality of mapped images from the plurality of raster images and a plurality of sets of ranges of counts, each mapped image including a plurality of pixels, each pixel having an output intensity determined by the specific range of counts that contains the corresponding rasterizer image pixel count, and a display device configured to display the plurality of mapped images and provide an indication as to at least one of the limitations on the totality of counts in a rasterizer image.

In some oscilloscope examples each of the plurality of sets of ranges of counts is defined by two of a plurality of output intensity thresholds.

In some oscilloscope examples the plurality of sets of ranges of counts includes 8 output intensity ranges.

In some oscilloscope examples the plurality of sets of ranges of counts includes 8 output intensity thresholds.

In some oscilloscope examples the plurality of sets of ranges of counts includes 16 output intensity ranges.

In some oscilloscope examples the plurality of sets of ranges of counts includes 16 output intensity thresholds.

Examples provide a method, comprising an oscilloscope acquiring a plurality of input data, a digitizer of the oscilloscope digitizing the plurality of input data into a plurality of digitized signals, a rasterizer of the oscilloscope generating a plurality of raster images from the plurality of digitized signals, each raster image including a plurality of pixels, each pixel having a count of the number of signals that pass through it, a processor of the oscilloscope generating a plurality of mapped images from the plurality of raster images and a plurality of sets of ranges of counts, each mapped image including a plurality of pixels, each pixel having an output intensity determined by the specific range of counts that contains the corresponding rasterizer image pixel count, and a display of the oscilloscope displaying the plurality of mapped images and providing an indication as to at least one of the limitations on the totality of counts in a rasterizer image.

In some method examples each of the plurality of sets of ranges of counts is defined by two of a plurality of output intensity thresholds.

In some method examples the plurality of sets of ranges of counts includes 8 output intensity ranges.

In some method examples the plurality of sets of ranges of counts includes 8 output intensity thresholds.

In some method examples the plurality of sets of ranges of counts includes 16 output intensity ranges.

In some method examples the plurality of sets of ranges of counts includes 16 output intensity thresholds.

Some examples further comprise causing (e.g. by a user) a cursor to move over a selected area of infrequent counts, and the oscilloscope determining the actual hit counts for the selected area.

Some examples further comprise the oscilloscope providing percentages of the total number of waveforms for the selected area.

Having described and illustrated the principles of the invention with reference to illustrated embodiments, it will be recognized that the illustrated embodiments may be modified in arrangement and detail without departing from such principles, and may be combined in any desired manner. And although the foregoing discussion has focused on particular embodiments, other configurations are contemplated.

In particular, even though expressions such as "according to an embodiment of the invention" or the like are used herein, these phrases are meant to generally reference embodiment possibilities, and are not intended to limit the invention to particular embodiment configurations. As used herein, these terms may reference the same or different embodiments that are combinable into other embodiments.

Consequently, in view of the wide variety of permutations to the embodiments that are described herein, this detailed description and accompanying material is intended to be illustrative only, and should not be taken as limiting the scope of the invention. What is claimed as the invention, therefore, is all such modifications as may come within the scope of the following claims and equivalents thereto.

## Claims

1. An oscilloscope, comprising:
a digitizer configured to digitize acquired input data into a plurality of digitized signals;
a rasterizer configured to generate a plurality of raster images from the plurality of digitized signals, each raster image including a plurality of pixels, each pixel having a count of the number of signals that pass through it;
an input device configured to generate sets of ranges of counts from the totality of counts in a rasterizer image and selected limits on that totality;
a mapper configured to generate a plurality of mapped images from the plurality of raster images and a plurality of sets of ranges of counts, each mapped image including a plurality of pixels, each pixel having an output intensity determined by the specific range of counts that contains the corresponding rasterizer image pixel count; and
a display device configured to display the plurality of mapped images and provide an indication as to at least one of the limitations on the totality of counts in a rasterizer image.

2. The oscilloscope of claim 1, wherein each of the plurality of sets of ranges of counts is defined by two of a plurality of output intensity thresholds.

3. The oscilloscope of claim 1 or 2, wherein the plurality of sets of ranges of counts includes 8 output intensity ranges.

4. The oscilloscope of claim 1 or 2, wherein the plurality of sets of ranges of counts includes 8 output intensity thresholds.

5. The oscilloscope of claim 1 or 2, wherein the plurality of sets of ranges of counts includes 16 output intensity ranges.

6. The oscilloscope of claim 1 or 2, wherein the plurality of sets of ranges of counts includes 16 output intensity thresholds.

7. A method, comprising:
an oscilloscope acquiring a plurality of input data;
a digitizer of the oscilloscope digitizing the plurality of input data into a plurality of digitized signals;
a rasterizer of the oscilloscope generating a plurality of raster images from the plurality of digitized signals, each raster image including a plurality of pixels, each pixel having a count of the number of signals that pass through it;
a processor of the oscilloscope generating a plurality of mapped images from the plurality of raster images and a plurality of sets of ranges of counts, each mapped image including a plurality of pixels, each pixel having an output intensity determined by the specific range of counts that contains the corresponding rasterizer image pixel count; and
a display of the oscilloscope displaying the plurality of mapped images and providing an indication as to at least one of the limitations on the totality of counts in a rasterizer image.

8. The method of claim 7, wherein each of the plurality of sets of ranges of counts is defined by two of a plurality of output intensity thresholds.

9. The method of claim 7 or 8, wherein the plurality of sets of ranges of counts includes 8 output intensity ranges.

10. The method of claim 7 or 8, wherein the plurality of sets of ranges of counts includes 8 output intensity thresholds.

11. The method of claim 7 or 8, wherein the plurality of sets of ranges of counts includes 16 output intensity ranges.

12. The method of claim 7 or 8, wherein the plurality of sets of ranges of counts includes 16 output intensity thresholds.

13. The method of any of claims 7 to 12, further comprising:
causing a cursor to move over a selected area of infrequent counts; and
the oscilloscope determining the actual hit counts for the selected area.

14. The method of claim 13, further comprising the oscilloscope providing percentages of the total number of waveforms for the selected area.
